(19) Europäisches Patentamt

European Patent Office

Office européen des brevets

(11) EP 0 940 910 A1

## (12) EUROPEAN PATENT APPLICATION

(43) Date of publication:
08.09.1999 Bulletin 1999/36

(51) Int. Cl.⁶: $H03F\ 1/02$, $H03G\ 3/20$

(21) Application number: 98103679.1

(22) Date of filing: 03.03.1998

(84) Designated Contracting States:
AT BE DE DK ES FI FR GB GR IE IT LU MC NL PT SE

(71) Applicant: ROBERT BOSCH GMBH
70442 Stuttgart (DE)

(72) Inventor: Madsen, Ulrik
9000 Aalborg (DK)

(54) **Power amplifier for a radio transmitter and mobile telephone with a radio transmitter**

(57) The invention relates to a power amplifier for a radio transmitter and a mobile telephone with a radio transmitter, comprising a power amplification stage 1 and a voltage supply 2. The radio transmitter is capable to transmit radio signals on different levels of radio output power. The level of radio output power is controlled by radio output power signal 5,8 applied directly to the amplification stage 1 and to the voltage supply 2. The working power applied by the voltage supply 2 is controlled by the radio output power signal. The amplification factor of the amplification stage 1 is controlled by the applied working voltage level and by the radio output power signal applied to the input 5.

Fig. 1

Printed by Xerox (UK) Business Services
2.16.7/3.6

## Description

Prior Art

The invention proceeds from a power amplifier for a radio transmitter or a mobile telephone with radio transmitter in accordance with a generic class of the independent patent claims. It is already well known, that power amplifier which are used for radio transmitters in mobile telephones must allow a precise control of the power level of the outputted radio frequency signal. An example for such a mobile telephone system is the GSM mobil telephone system, where the output power level of a mobil telephone depends on the distance of the mobile telephone relative to a fixed base station. Mobil telephone systems that use CDMA require even more precise control of the radio output power. Most mobil telephones are powered by rechargeable batteries with very limited power capacity.

Advantages of the invention

The power-amplifier and the mobil telephone having the characterizing features of the independent patent claims have the advantage of reduced power consumption. This is especially the case, when the power-amplifier is operated at lower output power levels.
The features of the dependent patent claims enable further improvement of the invention. The voltage supply is arranged advantageous between a DC powersource and the power-amplifier. The voltage supply have therefor the form of a DC/DC-converter. The power amplification stage comprises an input for radio frequency signal, an output for an amplified radio frequency signal, an input for the supply voltage and an input for a radio output power signal which controls the amplification. The voltage of the voltage-input and the radio output power signal determine the level of amplification of the power amplification stage.

Drawings

Examples of the invention are shown in the figures and explained in greater detail in the description below. Figure 1 shows a power-amplifier according to the invention, figure 2 power-amplification stages in greater detail and figure 3 a mobile telephone and a base station.

Description

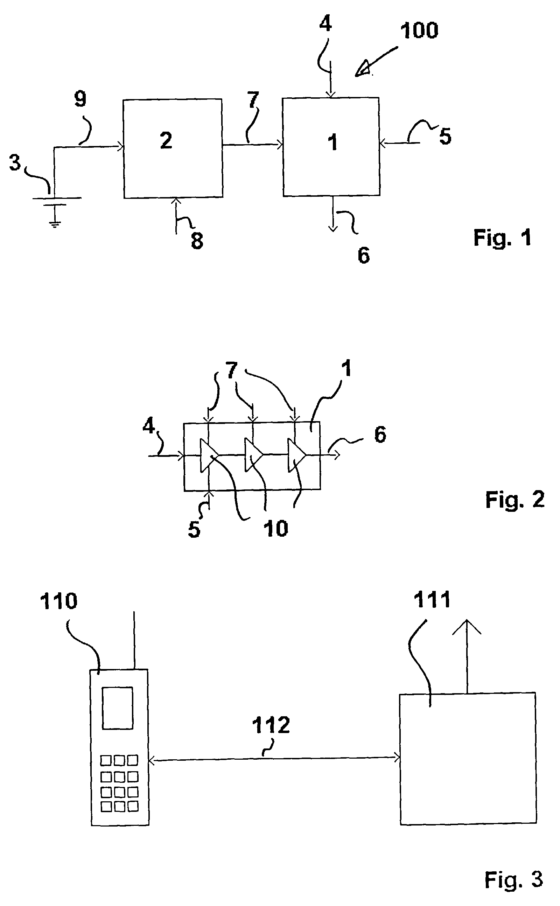

Figure 1 shows a power-amplifier 100 comprising a power-amplification stage 1 and voltage supply 2. The power-amplifier 100 is designed for a radio transmitter. The power-amplification stage 1 therefore has a radio frequency signal input 4 for receiving a radio frequency signal, and a radio frequency output 6 for the amplified radio frequency signal. The power-amplifier stage 1 further comprises a power level input 5, at which a power level signal can be applied, for adjusting the amplification factor of the power-amplification stage 1. The power-amplification stage 1 further comprises an input 7 for the supply voltage. The supply voltage at the input 7 is supplied by voltage supply 2 which is connected via a connection line 9 to an energy source. The energy for a mobile telephone is normally supplied by a battery 3, which is shown in figure 1. The voltage supply 2 also has a further input 8 at which the power level signal of input 5, or a signal derived from the signal at input 5, as applied. Dependent on the signal at input 8 the supply voltage on line 7 can be influenced. The supply voltage on line 7 also influences the amplification factor of the power-amplification stage 1.
The power-amplifier 100 of figure 1 has therefor two possibilities to control the amplification factor. The amplification factor of the power-amplification stage 1 therefor is a function of the working voltage applied on line 7 and a function of the power level signal applied at input 5.
This two possibilities of influencing the power amplification factor are especially useful for the power added efficiency of the power amplifier 100. The power added efficiency is here defined by the relation between the power consumed from the battery 3 ($P_{DC}$) compared to the difference of output power ($P_{out}$) and input power ($P_{in}$):

$$\text{power added efficiency} = (P_{out} - P_{in}) / (P_{DC}).$$

If the power amplification factor of the power amplification stage 1 is high, the power added efficiency is normally good, which means that the radio frequency signal at output 6 contains about 50 % of the power consumed from the battery 3. For low amplification factors and without the possibility to influence the voltage level on line 7, the power added efficiency decreases to the order of only a few percent. Typical values give a power added efficiency of 45% for 33 dBm amplification an the power added efficiency of only 3 % for 10 dBm amplification. The power added efficiency in the low amplification range can be increased by lowering the supply voltage on line 7 if only a low amplification is required. This is especially useful for application of the power amplifier in a mobile telephone.
Figure 3 shows a mobile telephone 110 and a fixed base station 111 that communicates to each others via radio signals. The power of the radio signal is adjusted according to a distance 112. If the mobile telephone 110 and the base station 111 are only separated by a verry short distance, only a low power level of the radio signal is required. If they are separated by a large distance, the energy level of the radio signal is accordingly increased. Within large towns there are normally many base stations, so that mobile telephone operate within towns normally on low energy levels. Therefore the batteries of these mobil telephones can be used much more efficient if the power amplification factor is also adjusted by controlling the voltage of the supply voltage of the power amplification stage 1.

Measurements show that the power consumed by the power amplifier (according to the invention) in the low amplification range is only 1/3 compared to the conventional power amplification stages without the invention. The operating time of the mobile telephone can be increased accordingly (this depends also on the power consumed by the other components of the mobil telephone).

Figure 2 shows a power amplification stage 1 comprising 3 transistor stages or sub-amplification stages 10. The first amplification stage receives the radio frequency signal input 4, amplifies the signal and passes it to the next sub-amplification stage 10. This amplification stage amplifies the signal further and passes it to the last sub-amplification stage 10 that passes the signal to the radio frequency signal output 6. All these sub-amplification stages 10 receive the supply voltage 7 and are therefor influenced by this voltage in their amplification. The power level signal 5 is only applied to the sub-amplification stage.

## Claims

1. Power amplifier (100) for a radio transmitter, the radio transmitter being capable to transmit on different levels of radio-output-power, the power amplifier (100) containing a power amplification stage (1), characterized by, a voltage supply (2), supplying a working voltage for the power amplification stage (1), the voltage supply (2) comprising a signal input (8), at which a radio output power signal is applicable, and the working voltage supplied by the power supplied (2) is controlled by a radio output power signal applied to the signal input (8).

2. Power amplifier according to claim 1, characterized by the working power been a DC voltage and the power supply (2) comprises a voltage input (9) for a DC input voltage.

3. Power amplifier according to claim 1 or 2, characterized by, the power amplification stage (1) comprising a first signal input (4) for a radio signal to be amplified, an output (6) for the amplified radio signal, a voltage input (7) for the working voltage and a second signal input (5) for a radio output power signal, the voltage at the voltage input (7) and the radio output power signal at the second input (5) determining the level of radio output power at the output (6).

4. Power amplifier according to claim 3, characterized by the power amplification stage (10) comprising a plurality of sub-amplification stages (10), each of the sub-amplification stages (10) being connected to the voltage input (7), and at least one of the sub-amplification stages (10) being connected to the second input signal (5).

5. Mobile telephone (110) with a radio transmitter comprising a power amplifier (100), the radio transmitter being capable to transmit different levels of radio output power, the power amplifier (100) comprises a power amplification stage 1, characterized by, means (2) to supply a working voltage for the power amplification stage (1), and means for varying the working voltage as function of a selected level of radio output power.

6. Mobile telephone according to claim 5, characterized by the means for supply of working voltage being a DC/DC-converter.

7. Mobile telephone according to claim 6, characterized by the DC/DC-converter being connected to a battery (3).

Fig. 1

Fig. 2

Fig. 3

EP 0 940 910 A1

**European Patent Office**

# EUROPEAN SEARCH REPORT

Application Number

EP 98 10 3679

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | US 4 636 741 A (MITZLAFF JAMES E) 13 January 1987<br>* column 2, line 31 - column 9, line 17; figures 1-10 *<br>--- | 1-7 | H03F1/02<br>H03G3/20 |
| Y | GB 2 239 755 A (MITSUBISHI ELECTRIC CORP) 10 July 1991<br>* page 6, line 23 - page 7, line 2; figure 2 *<br>--- | 1-7 | |
| A | EP 0 626 765 A (SONY CORP) 30 November 1994<br>* column 4, line 50 - column 5, line 17; figure 3 *<br>--- | 1-7 | |
| A | EP 0 481 741 A (HITACHI LTD ;HITACHI TOHBU SEMICONDUCTOR LTD (JP)) 22 April 1992<br>* abstract; figure 3 *<br>----- | 1,3,4 | |
| | | | TECHNICAL FIELDS SEARCHED (Int.Cl.6) |
| | | | H03F<br>H03G |

The present search report has been drawn up for all claims

| Place of search | Date of completion of the search | Examiner |
|---|---|---|
| THE HAGUE | 3 July 1998 | Tyberghien, G |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

5